# EUROPÄISCHE PATENTANMELDUNG

(11) **EP 1 089 340 A2**
(43) Veröffentlichungstag der Anmeldung: **04.04.2001**
(21) Anmeldenummer: 00118593.3
(22) Anmeldetag: 28.08.2000
(51) Int. Cl.: H01L 27/115

(54) **Eprom-Struktur für Halbleiterspeicher**

(30) Priorität: 30.09.1999 DE 19946884
(71) Anmelder: Micronas GmbH, 79108 Freiburg (DE)
(72) Erfinder: Frerichs, Heinz-Peter, Dr., 79271 St. Peter (DE)
(74) Vertreter: Patentanwälte Westphal, Mussgnug & Partner

(57) **Zusammenfassung**

Es wird eine EPROM-Struktur für einen nichtflüchtigen Halbleiterspeicher mit einer Mehrzahl von Speicherzellen beschrieben, die jeweils einen Floating-Gate-Transistor (6) aufweisen, der über heiße Elektronen programmiert und mit UV-Licht gelöscht werden kann, wobei an jeder Speicherzelle eine zusätzliche, gemeinsame Gate-Kapazität (7) vorgesehen ist, die in der Weise angeordnet ist, daß eine zum Schreiben erforderliche Potentialanhebung an dem Floating-Gate Transistor (6) durch Anlegen einer vorbestimmbaren, für alle Speicherzellen gemeinsamen Spannung an die Gate-Kapazitäten erzielt wird.

## Beschreibung

Die Erfindung betrifft eine EPROM (Erasable and Programmable Read-Only Memory)-Struktur für einen nichtflüchtigen Halbleiterspeicher mit einer Mehrzahl von Speicherzellen, die jeweils einen Floating-Gate-Transistor aufweisen, der über heiße Elektronen programmiert und mit UV-Licht gelöscht werden kann, gemäß dem Oberbegriff von Anspruch 1.

EPROM-Strukturen dienen zum Aufbau von nichtflüchtigen Halbleiterspeichern insbesondere für integrierte Schaltungen (embedded EPROM) und allgemein zur Anwendung in Computern oder in mikroprozessorgesteuerten Vorrichtungen zur Speicherung von Programmen und / oder Daten, die auch ohne Versorgungsspannung erhalten bleiben sollen.

Jede Speicherzelle einer EPROM-Struktur weist im allgemeinen zwei Transistoren auf, nämlich einen Auswahl- oder Zugriffstransistor, mit dem die betreffende Speicherzelle ausgewählt wird, sowie einen Floating-Gate Transistor, dessen Floating-Gate durch entsprechende positive oder negative Aufladung einen gelöschten bzw. programmierten Zustand darstellt.

Zum Programmieren der Speicherzellen sind in der Regel Spannungen von mindestens 8 Volt auf Zellenebene und somit Spannungen von etwa 10 Volt für die Pass-Gates erforderlich. Diese Spannungen müssen bei den bekannten EPROM-Strukturen selektiv an jede zu programmierende oder zu löschende Speicherzelle angelegt werden. Dies bedeutet, daß Transistoren vorhanden sein müssen, die diese Spannungen schalten können. Da jede Speicherzelle selektiert werden muß, müssen die Transistoren außerdem hinreichend klein sein, um die gesamte Struktur und damit den Speicher nicht unverhältnismäßig groß werden zu lassen.

Ein Problem hierbei besteht darin, daß die üblicherweise hergestellten integrierten Schaltungen sowie ihre Herstellungsverfahren für 5 Volt oder weniger ausgelegt sind. Um die zur Einbettung von EPPOM-Strukturen notwendigen hohen Spannungen mit einem üblichen Herstellungsverfahren für integrierte Schaltungen handhaben zu können, sind in der Regel zahlreiche zusätzliche Prozeßschritte (im allgemeinen etwa fünf bis acht Maskenschritte) erforderlich, die den gesamten Prozeß und damit die integrierte Schaltung erheblich verteuern.

Aus der US-PS 5.212.541 ist eine EPROM- Speicherzellenstruktur bekannt, bei der die Speicherzellen jeweils einen Floating-Gate-Transistor aufweisen, der über heiße Elektronen geschrieben (programmiert) und mit UV-Licht gelöscht werden kann. Diese Speicherzellen können zwar recht gut mit einem bekannten CMOS-Herstellungsverfahren hergestellt werden Ein Nachteil besteht jedoch darin, daß zum Schreiben selektiv eine Spannung von 13 Volt an die betreffende Speicherzelle angelegt werden muß.

Der Erfindung liegt deshalb die Aufgabe zugrunde, eine EPROM-Struktur der eingangs genannten Art zu schaffen, bei der zum Betrieb keine Spannungen selektiv an die einzelnen Speicherzellen angelegt werden müssen, die wesentlich größer als 5 Volt sind.

Gelöst wird diese Aufgabe gemäß Anspruch 1 mit einer EPROM-Struktur der eingangs genannten Art, die sich durch eine zusätzliche, gemeinsame Gate-Kapazität an jeder Speicherzelle auszeichnet, die in der Weise angeordnet ist, daß eine zum Schreiben erforderliche Potentialanhebung an dem Floating-Gate Transistor durch Anlegen einer vorbestimmbaren, für alle Speicherzellen gemeinsamen Spannung an die Gate-Kapazitäten erzielt wird.

Ein besonderer Vorteil dieser Lösung besteht darin, daß die gemeinsame Spannung nicht dekodiert werden muß. Aus diesem Grund sind keine Hochspannungstransistoren mit anderen Gateoxid-Dicken und Diffusionen erforderlich. Hierdurch werden bei der Herstellung zahlreiche Masken- und Prozeßschritte eingespart, so daß auch die elektrischen Parameter der Standard-Transistoren durch zusätzliche Prozeßschritte nicht verändert werden. An der zusätzlichen Gate-Kapazität können hingegen auch Spannung mit mehr als 20 Volt anliegen, da diese nicht geschaltet werden müssen.

Ein wirtschaftlicher Vorteil besteht schließlich darin, daß sich die Herstellungsschritte für die EPROM-Struktur relativ problemlos und ohne großen Aufwand in ein übliches CMOS-Herstellungsverfahren für integrierte Schaltungen einfügen lassen.

Die Unteransprüche haben vorteilhafte Weiterbildungen der Erfindung zum Inhalt.

Danach ist die zusätzliche Gate-Kapazität vorzugsweise über dem Floating-Gate jeder Speicherzelle angeordnet. Weiterhin ist der Floating-Gate Transistor insbesondere ein Depletion n-Kanal Transistor, dessen Gate durch heiße Elektronen negativ aufgeladen wird, so daß der Floating-Gate Transistor einen "Aus" Zustand einnimmt.

Weitere Einzelheiten, Merkmale und Vorteile der Erfindung ergeben sich aus der folgenden Beschreibung einer bevorzugten Ausführungsform anhand der Zeichnung. Es zeigt:
- Fig. 1: eine schematische Draufsicht auf eine Speicherzelle einer erfindungsgemäßen EPROM-Struktur;
- Fig. 2: einen Querschnitt entlang der Linie A-A' in Figur 1 und
- Fig. 3: eine EPROM-Struktur mit einer 6 x 4 Bit-Speicherzellen-Anordnung.

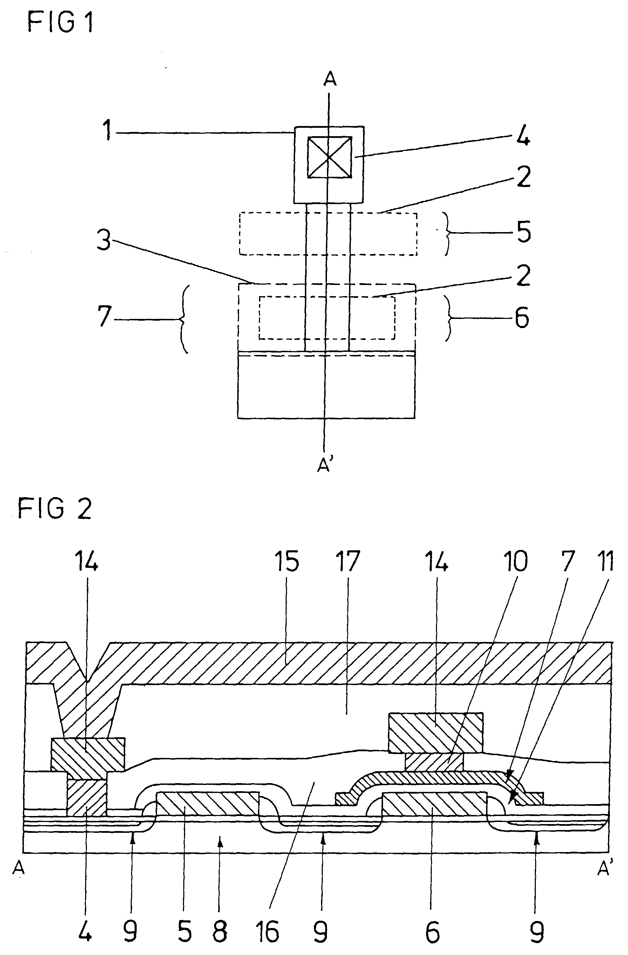

In Figur 1 ist als Teil einer bevorzugten EPROM-Struktur eine Speicherzelle mit Floating-Gate Transistor und Zugriffstransistor von oben dargestellt. Diese Struktur umfaßt in einem p-Substrat eine n-dotierte Diffusionsschicht 1, die über einen ersten Metallkontakt 4 kontaktiert ist. Daneben befindet sich eine erste Polyschicht 2a, mit der der Zugriffstransistor 5 gebildet ist. An diesen schließt sich eine zweite Polyschicht 2b an, mit der der Floating-Gate Transistor 6 erzeugt wird. Auf diesem befindet sich eine Kapazitätsschicht 3, mit der die gemeinsame Gate-Kapazität 7 gebildet wird.

Figur 2 zeigt einen Querschnitt durch diese Struktur entlang der Linie A-A' in Figur 1. In das p-Substrat 8 sind die n-dotierten Diffusionsschichten 1 durch Implantation eingebracht. Auf dem p-Substrat befindet sich der erste Metallkontakt 4, ein Gate 51 des Zugriffstransistors 5, sowie ein Floating-Gate 61 des Floating-Gate Transistors 6. Auf dem Gate 51 sowie dem Floating-Gate 61 befindet sich eine erste diektrische Schicht 11, die die gemeinsame Gate-Kapazität 7 im Bereich des Floating-Gates 61 trägt und diese von dem Floating-Gate isoliert. Auf diese Lagen ist eine zweite dielektrische Schicht 16 aufgebracht, in die mit bekannten fotolithographischen Verfahren Löcher für den ersten Metallkontakt 4 für die n-dotierte Diffusionsschicht 1 und einen zweiten Metallkontakt 10 für die gemeinsame Gate-Kapazität 7 eingeätzt werden. Zur Erzeugung dieser Kontakte werden die Löcher mit Metall gefüllt und darauf jeweils eine erste Metalllage 14 zur Kontaktierung aufgebracht. Auf diese Lagen wird eine dritte dielektrische Schicht 17 aufgebracht, die schließlich eine zweite Metallage 15 trägt, in die zur Kontaktierung mit der ersten Metalllage 14 entsprechende Löcher eingeätzt werden.

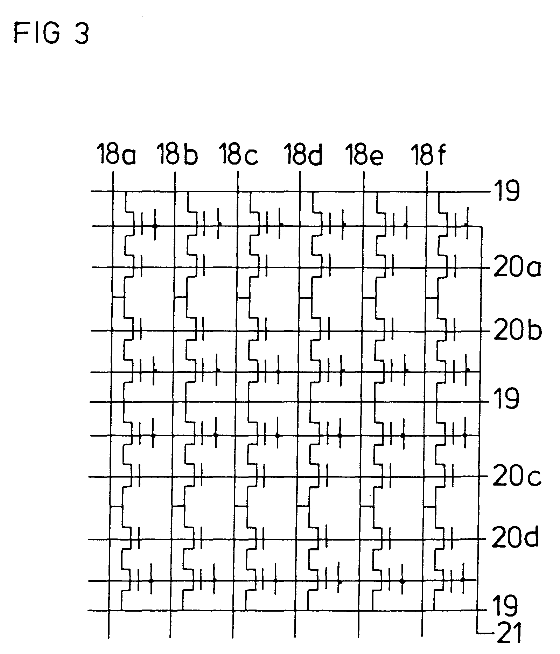

Figur 3 zeigt schließlich einen elektrischen Schaltplan für eine 6*4 Bit Speicherzellenanordnung. Über erste Leitungen 20a bis 20d werden die Zugriffstransistoren zur Auswahl der einzelnen Speicherzellen angesteuert. Zweite Leitungen 18a bis 18f, die die Bitleitungen darstellen, sind über die Zugriffstransistoren mit den EPROM-Speicherzellen verbunden. Dabei teilen sich immer zwei Reihen von Speicherzellen jeweils eine Sourceleitung 19. Eine Programmierleitung 21 ist schließlich mit der gemeinsamen Gate-Kapazität 7 für alle Speicherzellen verbunden.

Bei der beschriebenen erfindungsgemäßen Ausführungsform ist die EPROM-Speicherzelle eine 2-Transistor-Zelle mit einem Floating-Gate Transistor in Form eines Depletion n-Kanal Transistors, wobei die zur Programmierung erforderliche Potentialanhebung durch Anlegen einer Spannung an die gemeinsame Gate-Kapazität vorgenommen wird. Dies geschieht über die Programmierleitung 21 gemäß Figur 3, wobei die Spannung zwischen etwa 10 und 30 Volt liegt und von der Stärke der ersten dielektrischen Schicht 11 zwischen der gemeinsamen Gate-Kapazität 7 und dem Floating-Gate 61 abhängig ist. Die einzelne Speicherzelle wird dabei über eine der Zugriffsleitungen 20a bis 20d und über eine der Bitleitungen 18a bis 18f adressiert. Die adressierte Zelle weist eine Dram-Spannung von Vdd und eine Source-Spannung auf, die über die entsprechende Sourceleitung 19 angelegt wird. Die an der Dram-Seite erzeugten heißen Elektronen werden durch das hohe positive Potential an der gemeinsamen Gate-Kapazität, das über die Programmierleitung 21 angelegt wird, auf das Floating-Gate 61 gezogen. Dieses lädt sich dadurch negativ auf, so daß der Floating-Gate Transistor in den "Aus-" Zustand gelangt.

Zum Lesen einer Speicherzelle wird an die Programmierleitung 21 eine Spannung Vss bzw. 0 Volt angelegt. Die betreffende Zelle wird über eine der Bitleitungen 18a bis 18f und eine der Zugriffsleitungen 20a bis 20d adressiert und auf Stromfluß detektiert. Wenn das Floating-Gate 61 nicht geladen ist, so fließt ein Strom (Signal "1"), wenn es hingegen negativ geladen ist, fließt kein Strom (Signal "0").

Zum Löschen werden die Speicherzellen schließlich einem UV-Licht ausgesetzt, so daß die Ladungen auf den Floating-Gates beseitigt werden. Da die Floating-Gate Transistoren Depletion n-Kanal Transistoren sind, wird dadurch der Zustand "Ein" eingenommen, wobei ein Strom fließt und ein Signalwert "1" gelesen wird.

Ein wesentlicher Vorteil der Erfindung besteht darin, daß nur an die zusätzliche, gemeinsame Gate-Kapazität eine Spannung von mehr als 5 Volt gelegt werden muß, wobei diese Spannung für alle Zellen in der Speicheranordnung gemeinsam angelegt werden kann und somit nicht dekodiert werden muß. Folglich werden keine Hochspannungstransistoren benötigt, für die andere Gateoxiddicken und Diffusionen erforderlich sind, so daß zahlreiche Masken- und Prozeßschritte eingespart werden können. Außerdem werden die Standard-Transistoren in dem Prozeßablauf nicht durch zusätzliche Prozeßschritte hinsichtlich ihrer elektrischen Parameter verändert. Die für die zusätzlichen Kapazitäten erforderlichen Spannungen von mehr als 5 Volt können mit in jedem CMOS-Prozeß anfallenden MOS-Transistoren geschaltet werden, die zwar relativ groß sind, jedoch nur jeweils einmal vorhanden sein müssen.

## Patentansprüche

1. EPROM-Struktur für einen nichtflüchtigen Halbleiterspeicher, mit einer Mehrzahl von Speicherzellen, die jeweils einen Floating-Gate-Transistor aufweisen, der über heiße Elektronen geschrieben (programmiert) und mit UV-Licht gelöscht werden kann,
**gekennzeichnet durch**
eine zusätzliche gemeinsame Gate-Kapazität (7) an jeder Speicherzelle, die in der Weise angeordnet ist, daß eine zum Schreiben erforderliche Potentialanhebung an dem Floating-Gate Transistor (6) durch Anlegen einer vorbestimmbaren, für alle Speicherzellen gemeinsamen Spannung an die Gate-Kapazitäten (7) erzielt wird.

2. EPROM-Struktur nach Anspruch 1,
**dadurch gekennzeichnet,** daß der Floating-Gate Transistor (6) ein Depletion n-Kanal Transistor ist, dessen Gate durch heiße Elektronen negativ aufgeladen wird, so daß dieser einen "Aus" Zustand einnimmt.

3. EPROM-Struktur nach Anspruch 1 oder 2,
**dadurch gekennzeichnet,** daß die zusätzliche Gate-Kapazität (7) über dem Floating-Gate (61) des Floating-Gate Transistors (6) jeder Speicherzelle angeordnet ist.

4. EPROM-Struktur nach Anspruch 3,
**dadurch gekennzeichnet,** daß die zusätzliche Gate-Kapazität (7) durch eine dielektrische Schicht gebildet ist.

5. Integrierter Halbleiterspeicher mit einer EPROM-Struktur nach einem der vorhergehenden Ansprüche.
